(19) **Europäisches Patentamt**
**European Patent Office**
**Office européen des brevets**

(11) **EP 4 668 588 A1**

(12) **EUROPEAN PATENT APPLICATION**
published in accordance with Art. 153(4) EPC

(43) Date of publication:
24.12.2025 Bulletin 2025/52

(21) Application number: 24788004.0

(22) Date of filing: 07.04.2024

(51) International Patent Classification (IPC):
*H04B 1/12* (2006.01)

(52) Cooperative Patent Classification (CPC):
H04B 1/12; H04W 72/044; H04W 72/0453;
H04W 72/1268; H04W 72/21; H04W 72/50;
H04W 72/53

(86) International application number:
PCT/CN2024/086431

(87) International publication number:
WO 2024/212901 (17.10.2024 Gazette 2024/42)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 14.04.2023 CN 202310430550

(71) Applicant: Huawei Technologies Co., Ltd.
Shenzhen, Guangdong 518129 (CN)

(72) Inventors:
• GUO, Bei
Shenzhen, Guangdong 518129 (CN)
• LIU, Fengwei
Shenzhen, Guangdong 518129 (CN)
• PENG, Zhongchong
Shenzhen, Guangdong 518129 (CN)
• CHEN, Lei
Shenzhen, Guangdong 518129 (CN)

(74) Representative: Maiwald GmbH
Engineering
Elisenhof
Elisenstrasse 3
80335 München (DE)

(54) **NON-LINEAR COMPENSATION METHOD AND APPARATUS**

(57) This application provides a nonlinear compensation method and an apparatus, and relates to the field of wireless communication technologies, to improve accuracy of nonlinear compensation. In the method, a terminal device receives first indication information from a network device, where the first indication information indicates that a DMRS sequence includes a preset sequence whose PAPR is higher than that of a ZC sequence. The terminal device sends the preset sequence and data to the network device, where the data is carried on a physical uplink shared channel (physical uplink shared channel, PUSCH). A nonlinear estimation result of the preset sequence is used by the network device to perform nonlinear compensation on the PUSCH. The preset sequence and the data are transmitted by using a DFT-s-OFDM waveform. Based on this solution, because the preset sequence has a higher PAPR, the nonlinear estimation result of the preset sequence has higher accuracy, so that quality of nonlinear compensation at a receiving end can be improved.

FIG. 5

**Description**

CROSS-REFERENCE TO RELATED APPLICATIONS

This application claims priority to Chinese Patent Application No. 202310430550.6, filed with the China National Intellectual Property Administration on April 14, 2023 and entitled "NONLINEAR COMPENSATION METHOD AND APPARATUS", which is incorporated herein by reference in its entirety.

TECHNICAL FIELD

This application relates to the field of wireless communication technologies, and in particular, to a nonlinear compensation method and an apparatus.

BACKGROUND

A power amplifier (power amplifier, PA) may amplify a low-power signal generated by a base station or a terminal to a power level capable of long-range transmission, and is a core component of a wireless communication device. When power amplification is performed, the PA may cause nonlinear distortion, which results in deterioration of a performance indicator of a transmitted signal. For example, the nonlinear distortion caused by the PA may result in a decrease in performance of an error vector magnitude (error vector magnitude, EVM) and an adjacent channel leakage ratio (adjacent channel leakage ratio, ACLR) of the transmitted signal.

To resolve this problem, a receiving-end nonlinear compensation algorithm may be used. The receiving-end nonlinear compensation algorithm may be realized through nonlinear estimation of a demodulation reference signal (demodulation reference signal, DMRS). Currently, a Zadoff-Chu (zadoff-chu, ZC) sequence is usually used for a DMRS of discrete Fourier transform spread orthogonal frequency division multiplexing (discrete Fourier transform spread orthogonal frequency division multiplexing, DFT-s-OFDM). When a received signal cannot meet an EVM requirement and receiving-end nonlinear compensation needs to be performed, because a peak to average power ratio (peak to average power ratio, PAPR) of the DMRS for which the ZC sequence is used is low, a nonlinear estimation result cannot be accurately obtained by using the DMRS in a current slot.

SUMMARY

This application provides a nonlinear compensation method and an apparatus, to improve accuracy of nonlinear compensation.

According to a first aspect, a nonlinear compensation method is provided. The method may be performed by a terminal device, or may be performed by a chip/chip system. In the method, the terminal device receives first indication information from a network device, where the first indication information indicates that a DMRS sequence includes a preset sequence. A PAPR of the preset sequence is higher than a PAPR of a ZC sequence. For example, the preset sequence may be a pseudo-random sequence, for example, a Gold sequence. The terminal device sends the preset sequence and data to the network device, where the data is carried on a physical uplink shared channel (physical uplink shared channel, PUSCH). The preset sequence and the data are transmitted by using a DFT-s-OFDM waveform. A nonlinear estimation result of the preset sequence is used by the network device to perform nonlinear compensation on the PUSCH.

In the DFT-s-OFDM waveform, the ZC sequence is usually used as the DMRS sequence. Because the ZC sequence has a low PAPR, accuracy of a nonlinear estimation result is poor. Compared with the ZC sequence, the preset sequence has a higher PAPR, so that a PA is more likely to enter a nonlinear region, and a DMRS received signal generates more significant nonlinear distortion. The received signal with more significant nonlinear distortion is estimated to obtain a more accurate nonlinear estimation result, so that quality of nonlinear compensation at a receiving end can be improved.

In a possible implementation, the terminal device receives first configuration information from the network device, where the first configuration information is used to configure one or more of the following: a modulation scheme corresponding to the preset sequence, a modulation and coding scheme (modulation and coding scheme, MCS) corresponding to the preset sequence, and a value of PUSCH power boosting (power boosting, PB) corresponding to the preset sequence.

Based on this solution, the network device may configure the preset sequence with the higher PAPR as the DMRS sequence for the terminal device, to improve accuracy of DMRS nonlinear estimation, implement more accurate compensation for nonlinearity on a base station side, effectively improve EVM performance, and enable the terminal to reduce power back-off and increase a transmit power, thereby finally improving power amplification efficiency and enhancing uplink coverage.

In a possible implementation, the first indication information may be carried in downlink control information (down link control information, DCI), radio resource control (radio resource control, RRC) signaling, a medium access control (medium access control, MAC) control element (control element, CE), a system message (system information block, SIB), or a physical downlink shared channel (physical downlink shared channel, PDSCH). Based on this solution, the network device may indicate, to the terminal device by using common signaling information, that the DMRS sequence includes the preset sequence.

It may be understood that the first indication information may alternatively be carried in other signaling information or another channel.

In a possible implementation, the first indication information further indicates one or more of a modulation scheme and an MCS that correspond to the preset sequence. Based on this solution, the network device may indicate, to the terminal device based on a modulation scheme corresponding to the DMRS sequence and an MCS corresponding to the DMRS sequence that are configured for the terminal device, one or more of the modulation scheme corresponding to the preset sequence and the MCS corresponding to the preset sequence.

In a possible implementation, the first indication information indicates to enter an EVM boosting mode, the first indication information further indicates a first EVM indicator, and the first EVM indicator indicates that the DMRS sequence includes the preset sequence.

Based on this solution, the network device may indicate the first EVM indicator to the terminal device, to notify the terminal device to enter the EVM boosting mode, and also notify the terminal device that the DMRS sequence includes the preset sequence.

In a possible implementation, a time domain resource occupied by the preset sequence does not overlap a time domain resource occupied by the PUSCH. When the time domain resource for the preset sequence overlaps the time domain resource for the PUSCH, accuracy of nonlinear estimation of the preset sequence is low. Based on this solution, the time domain resource for the preset sequence does not overlap the time domain resource for the PUSCH, so that accuracy of nonlinear estimation of the preset sequence can be improved.

In a possible implementation, the terminal device receives second indication information from the network device, where the second indication information indicates information about a power difference between a power of the preset sequence and a power of the PUSCH. The terminal device sends the preset sequence and the data to the network device based on the information about the power difference.

Based on this solution, because the PAPR of the preset sequence and the PAPR of the PUSCH are different, and the preset sequence and the PUSCH have different average powers, to enable the preset sequence and the PUSCH to have same or similar nonlinearity at the receiving end, the network device may indicate, to the terminal device, the information about the power difference between the power of the preset sequence and the power of the PUSCH.

In a possible implementation, the terminal device receives second configuration information from the network device, where the second configuration information is used to configure one or more of the following: a modulation scheme corresponding to the information about the power difference, an MCS corresponding to the information about the power difference, and a value of PUSCH PB corresponding to the information about the power difference.

Based on this solution, when the network device configures the preset sequence with the higher PAPR as the DMRS sequence for the terminal device, the network device may further configure, for the terminal device, the information about the power difference between the power of the preset sequence and the power of the PUSCH, so that the preset sequence and the PUSCH have same or similar nonlinearity.

In a possible implementation, the second indication information may be carried in DCI, RRC signaling, a MAC CE, a SIB, or a PDSCH. Based on this solution, the network device may indicate the information about the power difference to the terminal device by using common signaling information.

It may be understood that the second indication information may alternatively be carried in other signaling information or another channel.

In a possible implementation, the second indication information further indicates one or more of a modulation scheme and an MCS that correspond to the information about the power difference. Based on this solution, the network device may indicate, to the terminal device based on the modulation scheme corresponding to the information about the power difference and the MCS corresponding to the information about the power difference that are configured for the terminal device, one or more of the modulation scheme corresponding to the information about the power difference and the MCS corresponding to the information about the power difference.

In a possible implementation, the second indication information indicates to enter an EVM boosting mode, the second indication information further indicates a second EVM indicator, and the second EVM indicator indicates the information about the power difference.

Based on this solution, the network device may indicate the first EVM indicator to the terminal device, to notify the terminal device to enter the EVM boosting mode, and also notify the terminal device of the information about the power difference between the power of the preset sequence and the power of the PUSCH.

According to a second aspect, a nonlinear compensation method is provided. The method may be performed by a network device, or may be performed by a chip/chip system. In the method, the network device sends first indication information to a terminal device, where the first indication information indicates that a DMRS sequence includes a preset sequence. The network device receives a preset sequence and data from the terminal device, where the data is carried on a PUSCH. The network device performs nonlinear estimation based on the preset sequence, and performs nonlinear compensation on the PUSCH based on a nonlinear estimation result.

In a possible implementation, a discrete Fourier transform spread orthogonal frequency division multiplexing DFT-s-OFDM waveform is used for the preset sequence and the data.

In a possible implementation, the network device sends first configuration information to the terminal device, where the first configuration information is used to configure one or more of the following: a modulation scheme corresponding to the preset sequence, a modulation and coding scheme MCS corresponding to the preset sequence, and a value of PUSCH PB corresponding to the preset sequence.

In a possible implementation, the first indication information may be carried in DCI, RRC signaling, a MAC CE, a SIB, or a PDSCH.

In a possible implementation, the first indication information further indicates one or more of a modulation scheme and an MCS that correspond to the preset sequence.

In a possible implementation, the first indication information indicates to enter an EVM boosting mode, the first indication information further indicates a first EVM indicator, and the first EVM indicator indicates that the DMRS sequence includes the preset sequence.

In a possible implementation, a time domain resource occupied by the preset sequence does not overlap a time domain resource occupied by the PUSCH.

In a possible implementation, the network device sends second indication information to the terminal device, where the second indication information indicates information about a power difference between a power of the preset sequence and a power of the PUSCH. The preset sequence and the data meet the information about the power difference.

In a possible implementation, the network device sends second configuration information to the terminal device, where the second configuration information is used to configure one or more of the following: a modulation scheme corresponding to the information about the power difference, an MCS corresponding to the information about the power difference, and a value of PUSCH PB corresponding to the information about the power difference.

In a possible implementation, the second indication information may be carried in DCI, RRC signaling, a MAC CE, a SIB, or a PDSCH.

In a possible implementation, the second indication information further indicates one or more of a modulation scheme and an MCS that correspond to the information about the power difference.

In a possible implementation, the second indication information indicates to enter an EVM boosting mode, the second indication information further indicates a second EVM indicator, and the second EVM indicator indicates the information about the power difference.

According to a third aspect, a nonlinear compensation method is provided. The method may be performed by a terminal device and a network device. In the method, the network device sends first indication information to the terminal device, and the terminal device receives the first indication information from the network device. The first indication information indicates that a DMRS sequence includes a preset sequence. The terminal device sends the preset sequence and data to the network device, and the network device receives the preset sequence and the data from the terminal device. The data is carried on a PUSCH. The network device performs nonlinear estimation based on the preset sequence, and performs nonlinear compensation on the PUSCH based on a nonlinear estimation result.

In a possible implementation, a discrete Fourier transform spread orthogonal frequency division multiplexing DFT-s-OFDM waveform is used for the preset sequence and the data.

In a possible implementation, the network device sends first configuration information to the terminal device, and the terminal device receives the first configuration information from the network device. The first configuration information is used to configure one or more of the following: a modulation scheme corresponding to the preset sequence, a modulation and coding scheme MCS corresponding to the preset sequence, and a value of PUSCH PB corresponding to the preset sequence.

In a possible implementation, the first indication information may be carried in DCI, RRC signaling, a MAC CE, a SIB, or a PDSCH.

In a possible implementation, the first indication information further indicates one or more of a modulation scheme and an MCS that correspond to the preset sequence.

In a possible implementation, the first indication information further indicates a first EVM indicator, and the first EVM indicator indicates that the DMRS sequence includes the preset sequence.

In a possible implementation, a time domain resource occupied by the preset sequence does not overlap a time domain resource occupied by the PUSCH.

In a possible implementation, the network device sends second indication information to the terminal device, and the terminal device receives the second indication information from the network device, where the second indication information indicates information about a power difference between a power of the preset sequence and a power of the PUSCH. The preset sequence and the data meet the information about the power difference.

In a possible implementation, the network device sends second configuration information to the terminal device, and the terminal device receives the second configuration information from the network device. The second configuration information is used to configure one or more of the following: a modulation scheme corresponding to the information about the power difference, an MCS corresponding to the information about the power difference, and a value of PUSCH PB corresponding to the information about the power difference.

In a possible implementation, the second indication information may be carried in DCI, RRC signaling, a MAC CE, a SIB, or a PDSCH.

In a possible implementation, the second indication information further indicates one or more of a modulation scheme and an MCS that correspond to the information about the power difference.

In a possible implementation, the second indication information further indicates a second EVM indicator, and the second EVM indicator indicates the information about the power difference.

According to a fourth aspect, a communication apparatus is provided, and includes a processing unit and a transceiver unit.

The transceiver unit is configured to receive first indication information from a network device, where the first indication information indicates that a DMRS sequence includes a preset sequence. The processing unit is configured to generate the preset sequence and data. The transceiver unit is further configured to send the preset sequence and the data to the network device, where the data is carried on a PUSCH. A nonlinear estimation result of the preset sequence is used to perform nonlinear compensation on the PUSCH, and a DFT-s-OFDM waveform is used for the preset sequence and the data.

In a possible implementation, the transceiver unit is further configured to receive first configuration information from the network device, where the first configuration information is used to configure one or more of the following: a modulation scheme corresponding to the preset sequence, a modulation and coding scheme (modulation and coding scheme, MCS) corresponding to the preset sequence, and a value of PUSCH power boosting (power boosting, PB) corresponding to the preset sequence.

In a possible implementation, the first indication information may be carried in DCI, RRC signaling, a MAC CE, a SIB, or a PDSCH. It may be understood that the first indication information may alternatively be carried in other signaling information or another channel.

In a possible implementation, the first indication information further indicates one or more of a modulation scheme and an MCS that correspond to the preset sequence.

In a possible implementation, the first indication information indicates to enter an EVM boosting mode, the first indication information further indicates a first EVM indicator, and the first EVM indicator indicates that the DMRS sequence includes the preset sequence.

In a possible implementation, a time domain resource occupied by the preset sequence does not overlap a time domain resource occupied by the PUSCH.

In a possible implementation, the transceiver unit is further configured to receive second indication information from the network device, where the second indication information indicates information about a power difference between a power of the preset sequence and a power of the PUSCH. The terminal device sends the preset sequence and the data to the network device based on the information about the power difference.

In a possible implementation, the transceiver unit is further configured to receive second configuration information from the network device, where the second configuration information is used to configure one or more of the following: a modulation scheme corresponding to the information about the power difference, an MCS corresponding to the information about the power difference, and a value of PUSCH PB corresponding to the information about the power difference.

In a possible implementation, the second indication information may be carried in DCI, RRC signaling, a MAC CE, a SIB, or a PDSCH. It may be understood that the second indication information may alternatively be carried in other signaling information or another channel.

In a possible implementation, the second indication information further indicates one or more of a modulation scheme and an MCS that correspond to the information about the power difference.

In a possible implementation, the second indication information indicates to enter an EVM boosting mode, the second indication information further indicates a second EVM indicator, and the second EVM indicator indicates the information about the power difference.

According to a fifth aspect, a communication apparatus is provided, and includes a processing unit and a transceiver unit.

The transceiver unit is configured to send first indication information to a terminal device, where the first indication information indicates that a DMRS sequence includes a preset sequence. The transceiver unit is further configured to receive the preset sequence and data from the terminal device, where the data is carried on a PUSCH. A DFT-s-OFDM waveform is used for the preset sequence and the data. The processing unit is configured to perform nonlinear estimation based on the preset sequence, and perform nonlinear compensation on the PUSCH based on a nonlinear estimation result.

In a possible implementation, the transceiver unit is further configured to send first configuration information to the terminal device, where the first configuration information is used to configure one or more of the following: a modulation scheme corresponding to the preset sequence, a modulation and coding scheme MCS corresponding to the preset sequence, and a value of PUSCH PB corresponding to the preset sequence.

In a possible implementation, the first indication information may be carried in DCI, RRC signaling, a MAC CE, a SIB, or a PDSCH. It may be understood that the first indication information may alternatively be carried in other signaling information or another channel.

In a possible implementation, the first indication information further indicates one or more of a modulation scheme and an MCS that correspond to the preset sequence.

In a possible implementation, the first indication information indicates to enter an EVM boosting mode, the first indication information further indicates a first EVM indicator, and the first EVM indicator indicates that the DMRS sequence includes the preset sequence.

In a possible implementation, a time domain resource occupied by the preset sequence does not overlap a time domain resource occupied by the PUSCH.

In a possible implementation, the transceiver unit is further configured to send second indication information to the terminal device, where the second indication information indicates information about a power difference between a power of the preset sequence and a power of the PUSCH. The preset sequence and the data meet the information about the power difference.

In a possible implementation, the transceiver unit is further configured to send second configuration information to the terminal device, where the second configuration information is used to configure one or more of the following: a modulation scheme corresponding to the information about the power difference, an MCS corresponding to the information about the power difference, and a value of PUSCH PB corresponding to the information about the power difference.

In a possible implementation, the second indication information may be carried in DCI, RRC signaling, a MAC CE, a SIB, or a PDSCH. It may be understood that the second indication information may alternatively be carried in other signaling information or another channel.

In a possible implementation, the second indication information further indicates one or more of a modulation scheme and an MCS that correspond to the information about the power difference.

In a possible implementation, the second indication information indicates to enter an EVM boosting mode, the second indication information further indicates a second EVM indicator, and the second EVM indicator indicates the information about the power difference.

According to a sixth aspect, a communication apparatus is provided. The communication apparatus may be the communication apparatus in any one of the possible implementations of the third aspect or the fourth aspect in the foregoing embodiments, or a chip disposed in the communication apparatus in the third aspect or the fourth aspect. The communication apparatus includes a communication interface and a processor, and optionally, further includes a memory. The memory is configured to store a computer program, instructions, or data. The processor is coupled to the memory and the communication interface. When the processor reads the computer program, the instructions, or the data, the communication apparatus is enabled to perform the method performed by the terminal device in any one of the possible implementations of the first aspect, or the communication apparatus is enabled to perform the method performed by the network device in any one of the possible implementations of the second aspect.

It should be understood that the communication interface may be implemented as an antenna, a feeder, a codec, and the like in the communication apparatus. Alternatively, if the communication apparatus is a chip disposed in the terminal device or the network device, the communication interface may be an input/output interface of the chip, for example, an input/output pin. The communication apparatus may further include a transceiver, used by the communication apparatus to communicate with another device.

According to a seventh aspect, an embodiment of this application provides a chip system. The chip system includes a processor, and may further include a memory, configured to implement the method performed by the terminal device or the network device in any one of the possible implementations of the first aspect to the fourth aspect. In a possible implementation, the chip system further includes a memory, configured to store program instructions and/or data. The chip system may include a chip, or may include a chip and another discrete component.

According to an eighth aspect, this application provides a computer-readable storage medium. The computer-readable storage medium stores a computer program or instructions. When the computer program or the instructions are run, the method performed by the terminal device or the network device in the foregoing aspects is implemented.

According to a ninth aspect, a computer program product is provided. The computer program product includes computer program code or instructions. When the computer program code or the instructions are run, the method performed by the terminal device or the network device in the foregoing aspects is performed.

According to a tenth aspect, a communication apparatus is provided. The communication apparatus includes units or modules for performing the methods in the foregoing aspects.

According to an eleventh aspect, a chip system is provided, and includes a logic circuit and an input/output interface. The logic circuit is configured to perform the method performed by the terminal device or the network device. The input/output interface is configured to communicate with another apparatus.

According to a twelfth aspect, a system is provided, and includes at least one network device and at least one terminal device.

For beneficial effects of the second aspect to the twelfth aspect and the implementations of the second aspect to the twelfth aspect, refer to the descriptions of the beneficial effects of the method in the first aspect and the implementations of the first aspect.

BRIEF DESCRIPTION OF DRAWINGS

FIG. 1 is a diagram of a communication system used by a method provided in an embodiment of this application;
FIG. 2 is a diagram of an error vector;
FIG. 3 is a diagram of nonlinear distortion;
FIG. 4 is a diagram of nonlinear estimation and nonlinear compensation;
FIG. 5 is a schematic flowchart of a nonlinear compensation method according to an embodiment of this application;
FIG. 6 is a diagram of a communication apparatus according to an embodiment of this application.
FIG. 7 is a diagram of another communication apparatus according to an embodiment of this application;
FIG. 8 is a diagram of still another communication apparatus according to an embodiment of this application; and
FIG. 9 is a diagram of yet another communication apparatus according to an embodiment of this application.

DESCRIPTION OF EMBODIMENTS

For ease of understanding of the technical solutions provided in embodiments of this application, the following explains and describes technical terms in embodiments of this application.

(1) A preset sequence may be any sequence whose PAPR is higher than that of a ZC sequence. For example, the preset sequence may include a pseudo-random sequence. If a sequence, on the one hand, can be pre-determined, and can be repeatedly produced and replicated; and on the other hand, the sequence has a random characteristic of a random sequence, the sequence is referred to as the pseudo-random sequence.

Optionally, the pseudo-random sequence may include a Gold sequence. The Gold sequence is a pseudo-random sequence with a good characteristic proposed and analyzed by R. Gold in 1967 based on an m-sequence. The Gold sequence is formed by performing modulo 2 addition on a preferred pair of two m-sequences having an equal code length and a same code clock rate.

(2) PUSCH PB may be understood as that an actual transmit power of a PUSCH exceeds an original limited transmit power, or may be understood as that power back-off for a PUSCH is reduced.

The following describes in detail embodiments of this application with reference to the accompanying drawings of the specification.

The technical solutions in embodiments of this application may be applied to a new radio (New Radio, NR) system, a global system for mobile communications (Global System for Mobile communications, GSM) system, a code division multiple access (Code Division Multiple Access, CDMA) system, a wideband code division multiple access (Wideband Code Division Multiple Access, WCDMA) system, a general packet radio service (General Packet Radio Service, GPRS) system, a long term evolution (Long Term Evolution, LTE) system, an LTE frequency division duplex (Frequency Division Duplex, FDD) system, an LTE time division duplex (Time Division Duplex, TDD), a universal mobile telecommunication system (Universal Mobile Telecommunication System, UMTS), a worldwide interoperability for microwave access (Worldwide Interoperability for Microwave Access, WiMAX) communication system, and the like. This is not limited herein.

In embodiments of this application, a terminal device may be a device with a wireless transceiver function or a chip that may be disposed in any device, and may also be referred to as user equipment (user equipment, UE), an access terminal, a subscriber unit, a subscriber station, a mobile station, a remote station, a remote terminal, a mobile device, a user terminal, a wireless communication device, a user agent, or a user apparatus. The terminal device in embodiments of this application may be a mobile phone (mobile phone), a tablet computer (Pad), a computer having a wireless transceiver function, a virtual reality (virtual reality, VR) terminal, an augmented reality (augmented reality, AR) terminal, a wireless terminal in industrial control (industrial control), a wireless terminal in self driving (self driving), a wireless terminal in telemedicine (remote medical), a wireless terminal in a smart grid (smart grid), a wireless terminal in transportation safety (transportation safety), a wireless terminal in a smart city (smart city), a wireless terminal in a smart home (smart home), or the like.

A network device may be a next generation NodeB (next Generation NodeB, gNB) in an NR system, may be an evolved NodeB (evolutional NodeB, eNB) in an LTE system, may be a base transceiver station (base transceiver station, BTS) in a global system for mobile communications (global system for mobile communications, GSM) system or a code division multiple access (code division multiple access, CDMA) system, may be a NodeB (NodeB, NB) in a wideband code division multiple access (wideband code division multiple access, WCDMA) system, or the like.

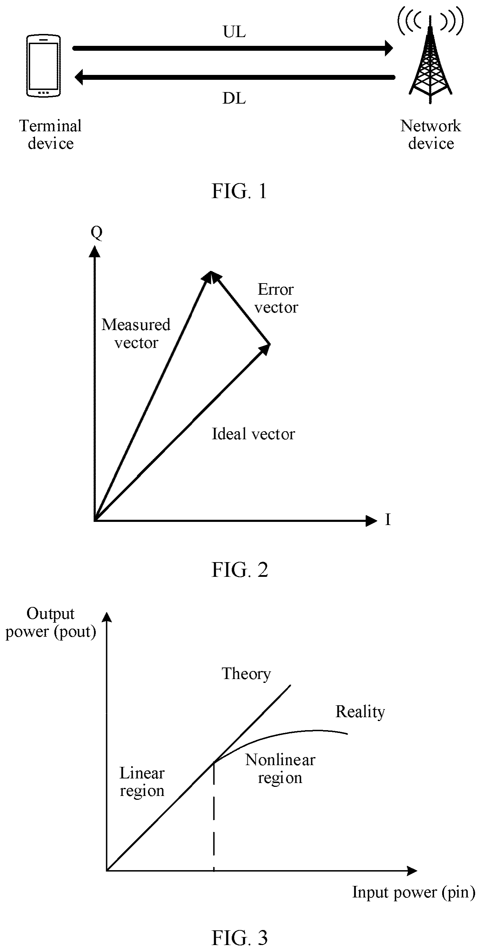

FIG. 1 is a diagram of a structure of a wireless communication system according to an embodiment of this application. As shown in FIG. 1, the wireless communication system includes a terminal device and a network device. FIG. 1 is merely an example. In actual application, connections may be established between a plurality of terminal devices and the network device. Based on different transmission directions, a transmission link from the terminal device to the network device is denoted as an uplink (uplink, UL), and a transmission link from the network device to the terminal device is denoted as a downlink (downlink, DL). Similarly, data transmission in an uplink may be denoted as uplink data transmission or uplink transmission for short, and data transmission in a downlink may be denoted as downlink data transmission or downlink transmission for short.

In the wireless communication system, the terminal device and the network device support one or more same radio access technologies (radio access technology, RAT), for example, NR and LTE. For ease of description, technical solutions in embodiments of this application are described in detail by using a base station and a terminal as an example in this application.

The terminal or the base station may include a radio frequency receive channel. The radio frequency receive channel may receive a radio frequency signal through an antenna, perform processing (for example, amplification, filtering, and down-conversion) on the radio frequency signal to obtain a baseband signal, and transfer the baseband signal to a baseband subsystem. A radio frequency transmit channel may receive the baseband signal from the baseband subsystem, perform radio frequency processing (such as up-conversion, amplification, and filtering) on the baseband signal to obtain a radio frequency signal, and finally radiate the radio frequency signal into space through the antenna.

Specifically, the radio frequency transmit channel may include electronic devices such as a low noise amplifier (low noise amplifier, LNA), a power amplifier (power amplifier, PA), a mixer (mixer), a local oscillator (local oscillator, LO), a filter (filter), and a digital to analog converter (digital to analog converter, DAC). These electronic devices may be integrated into one or more chips as required. Sometimes, the antenna may also be considered as a part of a radio frequency subsystem.

The radio frequency receive channel may include electronic devices such as a small-signal amplifier, a low noise amplifier (low noise amplifier, LNA), a power amplifier (power amplifier, PA), a mixer (mixer), a local oscillator (local oscillator, LO), a filter (filter), and an analog to digital converter (analog to digital converter, ADC). These electronic devices may be integrated into one or more chips as required. Sometimes, the antenna may also be considered as a part of the radio frequency subsystem.

The PA may amplify a low-power signal generated by a base station or a terminal to a power level capable of long-range transmission, and is a core component of a wireless communication device. When power amplification is performed, the PA may cause nonlinear distortion, as shown in FIG. 2, which results in deterioration of a performance indicator of a transmitted signal. For example, the nonlinear distortion caused by the PA may result in a decrease in performance of an error vector magnitude (error vector magnitude, EVM) and an adjacent channel leakage ratio (adjacent channel leakage ratio, ACLR) of the transmitted signal.

The EVM is defined as a square root of a ratio of an average power of an error vector to an average power of a reference signal. It may be understood as a ratio of an amplitude of an error signal vector to an amplitude of a reference signal vector. The error vector may include an amplitude vector and a phase vector, and is a vector difference between an ideal error-free reference signal and an actual transmitted signal at a given moment, and can comprehensively measure an amplitude error and a phase error of a modulated signal, as shown in FIG. 3. When the EVM exceeds a specific range, it is difficult to demodulate the signal successfully. Therefore, EVM indicators for different modulation schemes are specified in a protocol.

As described above, when the PA causes nonlinear distortion, EVM performance is affected. This is because an input power is high, so that the PA works in a near-saturation region with strong nonlinearity. Therefore, to avoid EVM performance deterioration caused by nonlinear distortion of the PA, when the input power exceeds a maximum input power that can enable the PA to work in a linear region, power back-off is usually used. Because different modulation schemes have different EVM indicators, the protocol specifies maximum power back-off corresponding to different modulation schemes.

As shown in Table 1, currently, terminal power back-off amounts of different waveforms for different modulation schemes are specified. A radio frequency capability of some frequency bands, for example, a millimeter wave frequency band, causes a large power back-off amount, which is close to a power back-off amount specified in the protocol. Power back-off causes high uplink transmission power consumption, resulting in problems such as poor uplink coverage and high terminal power consumption.

Table 1: Example of a terminal power back-off amount

|  | pi/2-BPSK | QPSK | 16QAM | 64QAM | 256QAM |
|---|---|---|---|---|---|
| OFDM | - | 4 dB | 5 dB | 7.5 dB | 11 dB |
| OFDM CA | - | 5 dB | 6.5 dB | 9 dB | - |
| DFT-s-OFDM | 0 dB | 2 dB | 3.5 dB | 5.5 dB | 9.5 dB |

The ACLR and the EVM are two radio frequency indicators that limit a terminal power. In some frequency bands, for example, the millimeter wave frequency band, a main constraint for increasing a transmit power of a terminal is the EVM. When the EVM is higher than a preset upper limit of the EVM, it indicates that the EVM deteriorates, and consequently demodulation performance deteriorates. To resolve this problem, a receiving-end nonlinear compensation algorithm may be used. For example, a transmit power is increased to a nonlinear region at a transmitter, and EVM performance is improved by using a nonlinear compensation technology at a receiver. The EVM of the signal is improved to increase the transmit power, thereby enhancing coverage and improving energy efficiency.

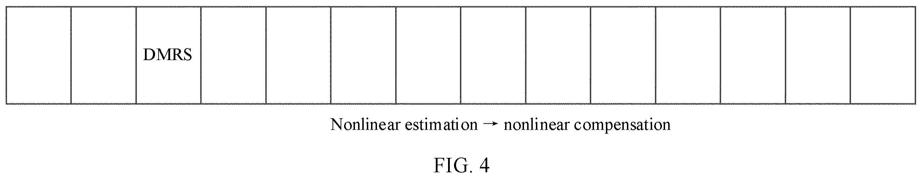

In a possible implementation, the receiving-end nonlinear compensation algorithm may be realized through nonlinear estimation of a DMRS, as shown in FIG. 4. In the algorithm, a nonlinear estimation result of the DMRS is used as a nonlinear estimation result of a data symbol, which has advantages of an accurate sample, high real-time performance, and a low EVM loss. Because the receiving-end nonlinear compensation algorithm is realized by using the nonlinear estimation result of the DMRS in a current slot, selecting different sequences as DMRS sequences affects a magnitude of nonlinear distortion, and consequently affects accuracy of nonlinear estimation. Therefore, for a discrete Fourier transform spread orthogonal frequency division multiplexing (discrete fourier transform spread orthogonal frequency division multiplexing, DFT-s-OFDM) waveform, which sequence is used as a DMRS sequence to improve accuracy of nonlinear estimation is a problem that needs to be resolved.

A DMRS sequence in an NR system mainly includes a ZC sequence, a Gold sequence, and the like. The ZC sequence may be generated according to the following formula (1):

$$x_q(m) = e^{-j\frac{\pi qm(m+1)}{N_{ZC}}}, 0 \leq m \leq N_{ZC} - 1 \qquad \text{Formula (1)}$$

m is a serial number of the sequence, q is a root index of the sequence, and $N_{ZC}$ is a sequence length. It is not difficult to learn that, the ZC sequence remains a ZC sequence in both time domain and frequency domain, with a constant amplitude. Therefore, there is a low peak to average power ratio (peak to average power ratio, PAPR). A length of the Gold sequence is 31, and may be generated according to the following formula (2):

$$c(n) = [x_1(n + N_C) + x_2(n + N_C)]\text{mod}2 \qquad \text{Formula (2)}$$

$$x_1(n + 31) = [x_1(n + 3) + x_1(n)]\text{mod}2$$

$$x_2(n + 31) = [x_2(n + 3) + x_2(n + 2) + x_2(n + 1) + x_2(n)]\text{mod}2$$

n = 0,1, ... , $M_{PN}$, $M_{PN}$ is a length of the output sequence c(n), and $N_C$ = 1600.

An initialization process of $x_1$ (n) is:

$$x_1(0) = 1, x_1(n) = 0, n = 1,2, ...,30$$

An initialization process of $x_2$ (n) is:

$$c_{init} = \sum_{i=0}^{30} x_2(i) * 2^i$$

$c_{init}$ represents an initial sequence.

Compared with the ZC sequence, the Gold sequence has a higher PAPR. However, currently, the ZC sequence is usually used for the DFT-s-OFDM DMRS. When DFT-s-OFDM cannot meet the EVM requirement and receiving-end nonlinear compensation needs to be performed, because the PAPR of the DMRS for which the ZC sequence is used is low, the nonlinear estimation result cannot be accurately obtained by using the DMRS in the current slot.

In view of this, embodiments of this application provide a communication method. In the method, a terminal may receive first indication information from a base station, where the first information may indicate that a DMRS sequence includes a Gold sequence. The terminal may send the Gold sequence and data to the base station. The data may be carried on a PUSCH. Therefore, the base station may perform nonlinear compensation on the PUSCH based on a nonlinear estimation result of the Gold sequence. Based on this solution, because the Gold sequence has a higher PAPR, the nonlinear estimation result of the Gold sequence has higher accuracy, so that quality of nonlinear compensation at a receiving end can be improved.

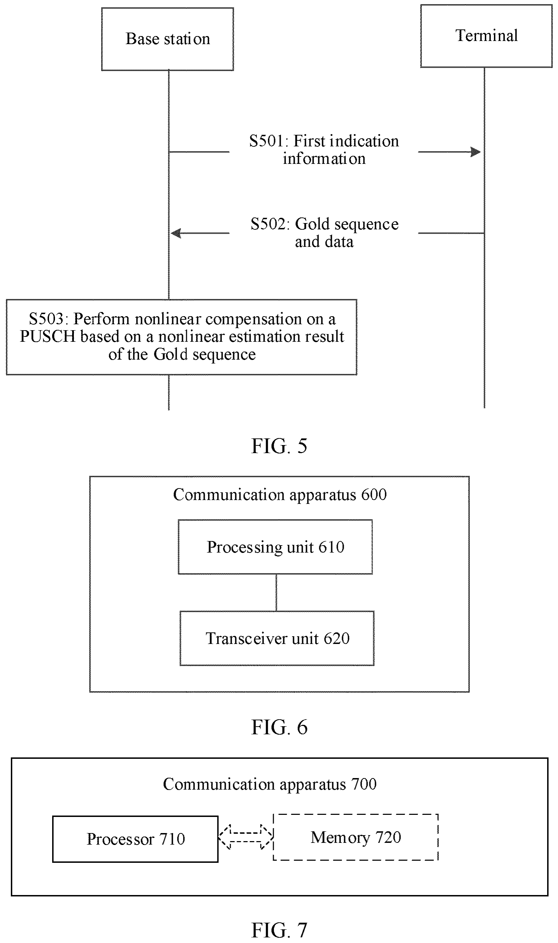

FIG. 5 is a schematic flowchart of a communication method according to an embodiment of this application. The method may include the following operations.

S501: A base station sends first indication information to a terminal.

Correspondingly, the terminal receives the first indication information from the base station.

The first indication information may indicate that a DMRS sequence includes a preset sequence. Alternatively, the first indication information may indicate the terminal to use a Gold sequence as a preset sequence. In other words, the first indication information may indicate the terminal to send the DMRS sequence in a form of the preset sequence, or the first indication information indicates the terminal to send the DMRS sequence by using the preset sequence. In this embodiment of this application, an example in which the preset sequence is the Gold sequence is used for description. The Gold sequence and the preset sequence in the following may be replaced with each other.

S502: The terminal sends the Gold sequence and data to the base station.

Correspondingly, the base station receives the Gold sequence and the data from the terminal.

The data may be carried on a PUSCH. It may be understood that, in addition to carrying the data, the PUSCH may further carry other information. This is not limited in this application.

In a possible case, the Gold sequence and the data may be transmitted by using a DFT-s-OFDM waveform. In other words, this embodiment of this application may be applied to a single-carrier signal scenario.

S503: The base station performs nonlinear compensation on the PUSCH based on a nonlinear estimation result of the Gold sequence.

For example, the base station may perform nonlinear estimation on the Gold sequence. In this way, the base station may obtain the nonlinear estimation result of the Gold sequence, and perform nonlinear compensation on the PUSCH based on the nonlinear estimation result.

As described above, a ZC sequence is usually used as the DMRS sequence of DFT-s-OFDM. In some cases, when DFT-s-OFDM cannot meet an EVM requirement and receiving-end nonlinear compensation needs to be performed, because a PAPR of the ZC sequence is low, nonlinearity cannot be accurately estimated by using a DMRS.

Based on the foregoing solution, the foregoing problem can be resolved by replacing the ZC sequence with the Gold sequence for the DMRS sequence of DFT-s-OFDM. Compared with the ZC sequence, the Gold sequence has a higher PAPR, so that a PA is more likely to enter a nonlinear region, and a DMRS received signal generates more significant nonlinear distortion. The received signal with more significant nonlinear distortion is estimated to obtain a more accurate nonlinear estimation result.

In a possible implementation, in S501, the base station may indicate, to the terminal by using signaling information, that the DMRS sequence includes the Gold sequence, or the base station may configure an EVM boosting mode for the terminal, to indicate that the DMRS sequence of the terminal includes the Gold sequence. The following provides descriptions in a manner 1 and a manner 2.

Manner 1

In this manner, the first indication information in S501 may be carried in signaling information of any common type, for example, downlink control information (download control Information, DCI), radio resource control (radio resource control, RRC) signaling, a MAC control element (MAC control element, MAC CE), a system message (system information blocks, SIB), or a physical downlink shared channel (physical downlink shared channel, PDSCH).

The following uses DCI as an example to describe that the base station indicates to the terminal that the DMRS sequence includes the Gold sequence. In S501, the base station may send DCI to the terminal, where the DCI may indicate that the DMRS sequence includes the Gold sequence, that is, the DCI may indicate the terminal to use the Gold sequence as the DMRS sequence. For example, a new field may be added to the DCI to indicate that the DMRS sequence includes the Gold sequence, or an existing field may be reused to indicate that the DMRS sequence includes the Gold sequence. This is not specifically limited in this application.

Optionally, the DCI may further indicate an MCS of the terminal, as shown in Table 2.

Table 2: Example of indicating a DMRS sequence by DCI

| DCI format | MCS | DMRS sequence | ... |
|---|---|---|---|
| 0-0/0-1 | C | ZC | ... |
| 0-0/0-1 | D | Gold | ... |

Optionally, the DCI may further indicate a modulation scheme of the terminal, as shown in Table 3.

Table 3: Example of indicating a DMRS sequence by DCI

| DCI format | Modulation scheme | DMRS sequence | ... |
|---|---|---|---|
| 0-0/0-1 | A | ZC | ... |
| 0-0/0-1 | B | Gold | ... |

Optionally, the DCI may further indicate PUSCH PB of the terminal, as shown in Table 4.

Table 4: Example of indicating a DMRS sequence by DCI

| DCI format | PUSCH PB | DMRS sequence | ... |
|---|---|---|---|
| 0-0/0-1 | E | ZC | ... |
| 0-0/0-1 | F | Gold | ... |

As shown in Table 2 to Table 4, the base station may indicate, to the terminal by using the DCI, one or more of the MCS, the modulation scheme, and the PUSCH PB, and indicate whether the DMRS sequence is the ZC sequence or the Gold sequence. It may be understood that Table 2 to Table 4 are merely used as examples of content indicated by the DCI, and do not constitute a specific limitation on the content indicated by the DCI. Table 2 to Table 4 may be a subset of the content indicated by the DCI, or may be a complete set of the content indicated by the DCI.

Similarly, RRC is used as an example to describe that the base station indicates to the terminal that the DMRS sequence includes the Gold sequence. In S501, the base station returns an RRC signaling message to the terminal, for example, an RRC connection setup (RRC Connection setup) message or an RRC reconfiguration (RRC reconfiguration) message. The RRC signaling message carries detailed information about a resource configuration of a signaling resource bearer (signaling resource bearer, SRB) 1. The terminal receives the RRC signaling message, for example, the RRC connection setup message or the RRC reconfiguration message. The RRC signaling message indicates the terminal to perform DMRS sequence configuration. The RRC signaling message may indicate that the DMRS sequence includes the Gold sequence, that is, the RRC signaling message may indicate the terminal to use the Gold sequence as the DMRS sequence. For example, a new field may be added to the RRC signaling message to indicate that the DMRS sequence includes the Gold sequence, or an existing field may be reused to indicate that the DMRS sequence includes the Gold sequence. This is not specifically limited in this application.

Optionally, the RRC signaling message may further indicate a modulation scheme, an MCS, PUSCH PB, and the like of the terminal, as shown in Table 5 to Table 7 respectively.

Table 5: Example of indicating a DMRS sequence by an RRC signaling message

| MCS | DMRS sequence | ... |
|---|---|---|
| C | ZC | ... |
| D | Gold | ... |

Table 6: Example of indicating a DMRS sequence by an RRC signaling message

| Modulation scheme | DMRS sequence | ... |
|---|---|---|
| A | ZC | ... |
| B | Gold | ... |

Table 7: Example of indicating a DMRS sequence by an RRC signaling message

| PUSCH PB | DMRS sequence | ... |
|----------|---------------|-----|
| E | ZC | ... |
| F | Gold | ... |

As shown in Table 5 to Table 7, the base station may indicate, to the terminal by using the RRC signaling message, one or more of the MCS, the modulation scheme, and the PUSCH PB, and indicate whether the DMRS sequence is the ZC sequence or the Gold sequence. It may be understood that Table 5 to Table 7 are merely used as examples of content indicated by the RRC signaling message, and do not constitute a specific limitation on the content indicated by the RRC signaling message. Table 5 to Table 7 may be a subset of the content indicated by the RRC signaling message, or may be a complete set of the content indicated by the RRC signaling message.

It may be understood that the first indication information may alternatively be carried in other signaling information. This is not specifically limited in this application.

In an example, a correspondence between one or more of the MCS, the PUSCH PB, and the modulation scheme and a type of the DMRS sequence may be preset or predefined in a protocol. In this way, a network device may indicate the type of the DMRS sequence by using the first indication information. Optionally, the network device may alternatively indicate one or more of the MCS, the PUSCH PB, and the modulation scheme by using the first indication information. It may be understood that the type of the DMRS sequence may include the ZC sequence or the Gold sequence.

In another example, the base station may further configure the DMRS sequence of the terminal. For example, the base station may send first configuration information to the terminal, where the first configuration information may be used to configure the type of the DMRS sequence of the terminal, and one or more of the modulation scheme corresponding to the type of the DMRS sequence, the MCS corresponding to the DMRS sequence, and a value of the PUSCH PB corresponding to the DMRS sequence. The following provides descriptions by using Table 8 to Table 11.

Table 8: Example of DMRS sequence configurations in different modulation schemes

| Modulation scheme | DMRS sequence |
|-------------------|---------------|
| A | ZC |
| B(B>A) | ZC/Gold |

In Table 8, the base station may configure a correspondence between the modulation scheme and the DMRS sequence. For example, when the modulation scheme is A, the base station may configure the DMRS sequence of the terminal to include the ZC sequence. For another example, when the modulation scheme is B, the base station may configure the DMRS sequence of the terminal to include the ZC sequence or the Gold sequence.

In this case, when selecting the modulation scheme A, the terminal may use the ZC sequence as the DMRS sequence. When selecting the modulation scheme B, the terminal may use the Gold sequence as the DMRS sequence.

It may be understood that A and B herein are merely examples. Actually, the base station may configure a modulation scheme threshold, for example, 64QAM, for the terminal. When the modulation scheme (for example, 16QAM) selected by the terminal is less than or equal to the modulation scheme threshold, the ZC sequence may be used as the DMRS sequence. When the modulation scheme (for example, 256QAM) selected by the terminal is greater than or equal to the modulation scheme threshold, the Gold sequence may be used as the DMRS sequence.

It can be learned from Table 8 that, when the modulation scheme of the terminal is a higher-order modulation scheme, the base station may configure the DMRS sequence of the terminal to include the Gold sequence. As shown in Table 9, compared with lower-order modulation, when the terminal in higher-order modulation relaxes a same EVM or reduces same power back-off, it is more difficult for an EVM to meet a corresponding EVM indicator, and more severe nonlinear distortion of a signal is caused. Therefore, the base station may configure the DMRS sequence of the terminal in the higher-order modulation scheme to include the Gold sequence, to improve accuracy of nonlinear estimation of the Gold sequence, and perform more accurate nonlinear compensation on the PUSCH.

Table 9: Example of EVM indicators in different modulation schemes

| Modulation scheme | Highest EVM in a protocol |
|-------------------|---------------------------|
| 256 quadrature amplitude modulation (quadrature amplitude modulation, QAM) | 3.5% |
| 64QAM | 8% |

(continued)

| Modulation scheme | Highest EVM in a protocol |
|---|---|
| 16QAM | 12.5% |
| Quadrature phase shift keying (quadrature phase shift keying, QPSK) | 17.5% |
| pi/2 binary phase shift keying (binary phase shift keying, BPSK) | 30% |

Table 10: Example of DMRS sequence configurations in different MCSs

| MCS | DMRS sequence |
|---|---|
| C | ZC |
| D(D>C) | ZC/Gold |

In Table 10, the base station may configure a correspondence between the MCS and the DMRS sequence. For example, when the MCS is C, the base station may configure the DMRS sequence of the terminal to include the ZC sequence. For another example, when the MCS is D, the base station may configure the DMRS sequence of the terminal to include the ZC sequence or the Gold sequence.

Similarly, C and D in Table 10 are merely examples. The base station may configure an MCS threshold for the terminal. Refer to the foregoing implementation of the modulation scheme threshold. Details are not described herein again.

It can be learned from Table 10 that, the base station may configure the DMRS sequence of the terminal to include the Gold sequence in a higher MCS. This is because a higher MCS usually corresponds to a lower-order modulation scheme. Compared with a higher-order modulation scheme corresponding to a smaller MCS, the higher MCS is more likely to encounter more severe nonlinear distortion of a signal. In addition, when different MCSs correspond to a same modulation scheme, although have same nonlinear distortion is generated in signals, because the higher MCS has a higher code rate and a higher requirement on EVM performance, more accurate nonlinear compensation needs to be performed.

Table 11: Example of DMRS sequence configurations for different PUSCH PB

| PUSCH PB | DMRS sequence |
|---|---|
| E dB | ZC |
| F dB(F>E) | ZC/Gold |

In Table 11, the base station may configure a correspondence between the PUSCH PB and the DMRS sequence. For example, when the PUSCH PB is E dB, the base station may configure the DMRS sequence of the terminal to include the ZC sequence. For another example, when the PUSCH PB is F dB, the base station may configure the DMRS sequence of the terminal to include the ZC sequence or the Gold sequence.

Similarly, E and F in Table 11 are merely examples. The base station may configure a PUSCH PB threshold for the terminal. Refer to the foregoing implementation of the modulation scheme threshold. Details are not described herein again.

During the PUSCH PB, a signal power back-off amount of the PUSCH is reduced, and a PA of the terminal may enter a nonlinear region to work, causing more severe nonlinear distortion. It can be learned from Table 11 that, in a case of high PUSCH PB, the base station may configure the DMRS sequence of the terminal to include the Gold sequence. This is because more severe nonlinear distortion may be caused in the case of high PUSCH PB. Therefore, when the Gold sequence with the higher PAPR is used as the DMRS sequence, and DMRS nonlinear estimation is also used to implement nonlinear compensation, compared with the ZC sequence, a base station side can implement more accurate nonlinear compensation.

It should be noted that Table 8, Table 10, and Table 11 are merely examples, and do not constitute a specific limitation on the first configuration information. Optionally, Table 8, Table 10, and Table 11 may alternatively be used as one table, and are configured by the base station for the terminal. Alternatively, Table 8, Table 10, and Table 11 each may be used as a subset of a restriction condition corresponding to the DMRS sequence configured by the base station for the terminal.

It may be understood that the base station may configure the DMRS sequence of the terminal and the corresponding restriction condition by using Table 8, Table 10, and Table 11, and then indicate the type of the DMRS sequence and one or more of the corresponding MCS, PUSCH PB, and modulation scheme to the terminal by using signaling information.

Based on the foregoing solution, the base station may configure the Gold sequence with the higher PAPR as the DMRS sequence for the terminal, to improve accuracy of DMRS nonlinear estimation, implement more accurate compensation for nonlinearity on the base station side, effectively improve EVM performance, and enable the terminal to reduce power back-off and increase a transmit power, thereby finally improving power amplification efficiency and enhancing uplink coverage.

Manner 2

In this manner, the base station may configure a first EVM indicator for the terminal.

For example, the base station may configure, based on a nonlinear compensation capability of the base station, relaxed first EVM indicators in different cases. Optionally, the base station configures, based on the nonlinear compensation capability of the base station, relaxed first EVM indicators in different modulation schemes, different waveforms, or different resource block (resource block, RB) allocation cases. In other words, the base station reconfigures largest values of an EVM for a signal sent by the terminal in different modulation schemes, different waveforms, or different RB allocation cases.

As shown in Table 12, in this case, it may represent that the terminal enters an EVM boosting mode, and the terminal may use the Gold sequence as the DMRS sequence. If the base station does not configure the first EVM indicator for the terminal, it may be considered that the EVM boosting mode is not turned on, and the terminal may use the ZC sequence as the DMRS sequence.

Table 12: Example of indicating a DMRS sequence in an EVM boosting mode

| EVM boosting mode | EVM boosting | DMRS sequence |
|---|---|---|
| OFF | | ZC |
| ON | G% (Δx%) | ZC/Gold |

It may be understood that, a form of the reconfigured first EVM indicator may be an absolute EVM indicator value, or may be an increment relative to an EVM indicator value specified in a protocol (for example, a relaxed EVM indicator - an EVM indicator specified in a protocol, or an EVM indicator specified in a protocol - a relaxed EVM indicator). When selecting different modulation schemes, different MCSs, different waveforms, or different RB allocation, the terminal performs power back-off based on the relaxed EVM indicator configured by the base station.

Optionally, a correspondence between a value of the first EVM indicator and a type of the DMRS sequence may be predefined in the protocol or preconfigured, or may be configured by the network device based on the foregoing content. This is not specifically limited in this application. In other words, a value of the EVM indicator that enters the EVM boosting mode may be predefined in the protocol or preconfigured, or may be configured by the network device based on the foregoing content. This is not specifically limited in this application.

Optionally, power back-off is performed based on the first EVM indicator reconfigured by the base station, that is, a first EVM of a signal sent by the terminal is less than the first EVM indicator reconfigured in a corresponding case. In this case, the base station may successfully demodulate the signal.

Based on the foregoing solution, the base station may indicate the type of the DMRS sequence to the terminal by using an EVM boosting mode indication. In comparison with that the type of the DMRS sequence is indicated by using signaling information such as DCI, RRC, a MAC CE, or a SIB, signaling overheads can be reduced.

Based on the foregoing content, this specification describes the technical solution in which the base station configures the DMRS sequence for the terminal and indicates the DMRS sequence to the terminal. Nonlinear estimation is performed on the DMRS sequence, and the nonlinear estimation result is used as a nonlinear estimation result of the PUSCH. Therefore, to ensure accuracy of nonlinear estimation, it is necessary to make the DMRS sequence and the signal of the PUSCH generate same or similar nonlinear distortion as much as possible. Considering that when the transmit power exceeds the maximum transmit power at which the PA works in the linear region, the PA works in the nonlinear region, which causes nonlinear distortion of the signal. Therefore, to enable the DMRS sequence and the received signal of the PUSCH to have same nonlinearity, the DMRS sequence and the received signal of the PUSCH need to have an equal peak power.

Optionally, when receiving-end nonlinear compensation is needed and the Gold sequence is used as the DMRS sequence, same-symbol frequency division is not performed on the DMRS sequence and the PUSCH. In other words, a time domain resource of the DMRS sequence does not overlap a time domain resource of the PUSCH.

In addition, because DFT transform is not performed on the DMRS in DFT-s-OFDM, and a PAPR of the DMRS is different from that of the PUSCH, to ensure that the DMRS and the PUSCH have more similar/same nonlinearity, information about a power difference needs to be configured.

In a possible implementation, the base station may send second indication information to the terminal, where the second indication information may indicate information about a power difference between a power of the DMRS sequence (including the Gold sequence) and a power of the PUSCH. In S502, the terminal may send the DMRS sequence and the data based on the information about the power difference. Optionally, the information about the power difference may be information about a power difference between a transmit power of the DMRS sequence and a transmit power of the PUSCH.

It should be noted that the second indication information and the first indication information may be same indication information, or may be different indication information. Similarly, the base station may indicate the information about the power difference to the terminal by using signaling information, or may configure an EVM boosting mode for the terminal, to indicate the information about the power difference. The following provides descriptions in a manner 3 and a manner 4.

Optionally, the information about the power difference may be a difference between the power of the DMRS sequence and the power of the PUSCH, a linear ratio between the power of the DMRS sequence and the power of the PUSCH, or another value that can represent a relationship between the power of the DMRS sequence and the power of the PUSCH. This is not specifically limited in this application.

Manner 3

In this manner, the second indication information may be carried in signaling information of any common type, for example, DCI, RRC signaling, a MAC CE, a SIB, or a PDSCH.

The following uses DCI as an example to describe that the base station indicates the information about the power difference to the terminal. The base station may send DCI to the terminal, where the DCI may indicate the information about the power difference between the power of the DMRS sequence and the power of the PUSCH. For example, a new field may be added to the DCI to indicate the information about the power difference, or an existing field may be reused to indicate the information about the power difference. This is not specifically limited in this application.

Optionally, the DCI may further indicate an MCS of the terminal, as shown in Table 13.

Table 13: Example of indicating information about a power difference by DCI

| DCI format | MCS | Power difference/linear ratio | ... |
|------------|-----|-------------------------------|-----|
| 0-0/0-1 | D | d dB/j | ... |

Optionally, the DCI may further indicate a modulation scheme of the terminal, as shown in Table 14.

Table 14: Example of indicating a DMRS sequence by DCI

| DCI format | Modulation scheme | Power difference/linear ratio | ... |
|------------|-------------------|-------------------------------|-----|
| 0-0/0-1 | B | d dB/j | ... |

Optionally, the DCI may further indicate PUSCH PB of the terminal, as shown in Table 15.

Table 15: Example of indicating a DMRS sequence by DCI

| DCI format | PUSCH PB | Power difference/linear ratio | ... |
|------------|----------|-------------------------------|-----|
| 0-0/0-1 | F | d dB/j | ... |

As shown in Table 13 to Table 15, the base station may indicate one or more of the MCS, the PUSCH PB, and the modulation scheme, and the information about the power difference to the terminal by using the DCI. It may be understood that Table 13 to Table 15 are merely used as examples of content indicated by the DCI, and do not constitute a specific limitation on the content indicated by the DCI. Table 13 to Table 15 may be a subset of the content indicated by the DCI, or may be a complete set of the content indicated by the DCI.

Similarly, RRC is used as an example to describe that the base station indicates the information about the power difference to the terminal. For example, the base station returns an RRC signaling message to the terminal, for example, an RRC connection setup (RRC Connection setup) message or an RRC reconfiguration (RRC reconfiguration) message. The RRC signaling message carries detailed information about a resource configuration of a signaling resource bearer (signaling resource bearer, SRB) 1. The terminal receives the RRC signaling message, for example, the RRC connection setup message or the RRC reconfiguration message. The RRC signaling message indicates the terminal to configure the information about the power difference, and the RRC signaling message may indicate the information about the power difference. For example, a new field may be added to the RRC signaling message to indicate the information about the power difference, or an existing field may be reused to indicate the information about the power difference. This is not specifically limited in this application.

Optionally, the RRC signaling message may further indicate a modulation scheme, an MCS, PUSCH PB, and the like of the terminal, as shown in Table 16 to Table 18 respectively.

Table 16: Example of indicating a DMRS sequence by an RRC signaling message

| MCS | Power difference/linear ratio | ... |
|---|---|---|
| D | d dB/j | ... |

Table 17: Example of indicating a DMRS sequence by an RRC signaling message

| Modulation scheme | Power difference/linear ratio | ... |
|---|---|---|
| B | d dB/j | ... |

Table 18: Example of indicating a DMRS sequence by an RRC signaling message

| PUSCH PB | Power difference/linear ratio | ... |
|---|---|---|
| F | d dB/j | ... |

As shown in Table 16 to Table 18, the base station may indicate one or more of the MCS, the modulation scheme, and the PUSCH PB, and the information about the power difference to the terminal by using the RRC signaling message. It may be understood that Table 16 to Table 18 are merely used as examples of content indicated by the RRC signaling message, and do not constitute a specific limitation on the content indicated by the RRC signaling message. Table 16 to Table 18 may be a subset of the content indicated by the RRC signaling message, or may be a complete set of the content indicated by the RRC signaling message.

It may be understood that the second indication information may alternatively be other signaling information. This is not specifically limited in this application.

Optionally, the signaling information indicating the information about the power difference and the signaling information indicating that the DMRS sequence includes the Gold sequence may be same signaling information. DCI is used as an example. In S501, the base station may send DCI to the terminal, where the DCI may indicate that the DMRS sequence includes the Gold sequence, and the DCI may further indicate information about a power difference between a power of the Gold sequence and a power of the PUSCH. Optionally, if the base station indicates, to the terminal in S501, that the DMRS sequence includes the ZC sequence, the DCI may not include information about a power difference between a power of the ZC sequence and the power of the PUSCH.

In an example, a correspondence between one or more of the MCS, the PUSCH PB, and the modulation scheme and the information about the power difference may be preset or predefined in a protocol. In this way, the network device may indicate the information about the power difference by using the second indication information. Optionally, the network device may alternatively indicate one or more of the MCS, the PUSCH PB, and the modulation scheme by using the second indication information.

In another example, the base station may further configure the information about the power difference of the terminal. For example, the base station may send second configuration information to the terminal, where the second configuration information may indicate the information about the power difference, and one or more of a modulation scheme corresponding to the information about the power difference, an MCS corresponding to the information about the power difference, and a value of PUSCH PB corresponding to the information about the power difference. The following provides descriptions by using Table 19 to Table 21.

Table 19: Example of a configuration of a power difference between a DMRS sequence and a PUSCH in different modulation schemes

| Modulation scheme | Power difference/linear ratio |
|---|---|
| A | a dB/g |

(continued)

| Modulation scheme | Power difference/linear ratio |
|---|---|
| B | b dB/h |

In Table 19, the base station may configure a correspondence between the modulation scheme and the information about the power difference. For example, when the modulation scheme is A, the base station may configure the power difference between the DMRS sequence and the PUSCH to be a dB or the linear ratio of the power of the DMRS sequence to the power of the PUSCH to be g. For another example, when the modulation scheme is B, the base station may configure the power difference between the DMRS sequence and the PUSCH to be b dB or the linear ratio of the power of the DMRS sequence to the power of the PUSCH to be h.

In this case, when selecting the modulation scheme A, the terminal may send the DMRS sequence and the data to the base station by using the power difference a dB or the linear ratio g. When selecting the modulation scheme B, the terminal may send the DMRS sequence and the data to the base station based on the power difference b dB or the linear ratio h.

It may be understood that A and B herein are merely examples. Actually, the base station may configure a modulation scheme threshold for the terminal, for example, 64QAM. When the modulation scheme (for example, 16QAM) selected by the terminal is less than or equal to the modulation scheme threshold, the DMRS sequence and the data may be sent to the base station based on the power difference a dB or the linear ratio g. When the modulation scheme (for example, 256QAM) selected by the terminal is greater than or equal to the modulation scheme threshold, the DMRS sequence and the data may be sent to the base station based on the power difference b dB or the linear ratio h.

Table 20: Example of a configuration of a power difference between a DMRS sequence and a PUSCH in different MCSs

| MCS | Power difference/linear ratio |
|---|---|
| C | c dB/i |
| D | d dB/j |

In Table 20, the base station may configure a correspondence between the MCS and the information about the power difference. For example, when the MCS is C, the base station may configure the power difference between the DMRS sequence and the PUSCH to be c dB or the linear ratio of the power of the DMRS sequence to the power of the PUSCH to be i. For another example, when the MCS is D, the base station may configure the power difference between the DMRS sequence and the PUSCH to be d dB or the linear ratio of the power of the DMRS sequence to the power of the PUSCH to be j.

In this case, when selecting the MCS C, the terminal may send the DMRS sequence and the data to the base station by using the power difference c dB or the linear ratio i. When selecting the MCS D, the terminal may send the DMRS sequence and the data to the base station based on the power difference d dB or the linear ratio j.

Similarly, C and D in Table 20 are merely examples. The base station may configure an MCS threshold for the terminal. Refer to the foregoing implementation of the modulation scheme threshold. Details are not described herein again.

Table 21: Example of a configuration of a power difference between a DMRS sequence and a PUSCH for different PUSCH PB

| PUSCH PB | Power difference/linear ratio |
|---|---|
| E dB | e dB/k |
| F dB | f dB/l |

In Table 21, the base station may configure a correspondence between the PUSCH PB and the DMRS sequence. For example, when the PUSCH PB is E dB, the base station may configure the power difference between the DMRS sequence and the PUSCH to be e dB or the linear ratio of the power of the DMRS sequence to the power of the PUSCH to be k. For another example, when the PUSCH PB is F dB, the base station may configure the power difference between the DMRS sequence and the PUSCH to be f dB or the linear ratio of the power of the DMRS sequence to the power of the PUSCH to be 1.

In this case, when selecting the value E of the PUSCH PB, the terminal may send the DMRS sequence and the data to the base station by using the power difference e dB or the linear ratio k. When selecting the value F of the PUSCH PB, the terminal may send the DMRS sequence and the data to the base station based on the power difference f dB or the linear ratio l.

Similarly, E and F in Table 21 are merely examples. The base station may configure a PUSCH PB threshold for the terminal. Refer to the foregoing implementation of the modulation scheme threshold. Details are not described herein again.

It should be noted that Table 19 to Table 21 are merely examples, and do not constitute a specific limitation on the first configuration information. Optionally, Table 19 to Table 21 may alternatively be used as one table, and are configured by the base station for the terminal. Alternatively, Table 19 to Table 21 each may be used as a subset of a restriction condition corresponding to the information about the power difference configured by the base station for the terminal.

Optionally, the second configuration information and the first configuration information may be same configuration information, or may be different configuration information.

Based on the foregoing solution, when configuring the Gold sequence with the higher PAPR as the DMRS sequence for the terminal, the base station may configure the information about the power difference between the power of the DMRS sequence and the power of the PUSCH for the terminal, so that the DMRS sequence and the PUSCH have the same or similar nonlinearity, to implement more accurate compensation for nonlinearity on the base station side, effectively improve EVM performance, and enable the terminal to reduce power back-off and increase the transmit power, thereby finally improving power amplification efficiency and enhancing uplink coverage.

Manner 4

In this manner, the base station may configure a second EVM indicator for the terminal.

For example, the base station may configure, based on a nonlinear compensation capability of the base station, relaxed second EVM indicators in different cases. Specifically, the base station configures, based on the nonlinear compensation capability of the base station, relaxed second EVM indicators in different modulation schemes, different waveforms, or different resource block (resource block, RB) allocation cases. In other words, the base station reconfigures largest values of an EVM for a signal sent by the terminal in different modulation schemes, different waveforms, or different RB allocation cases.

As shown in Table 22, in this case, it may represent that the terminal enters an EVM boosting mode, and the terminal may send the DMRS sequence and the data to the base station based on a power difference m dB or a linear ratio n.

Table 22: Example of indicating a configuration of information about a power difference by an EVM boosting mode

| EVM boosting mode | EVM boosting | Power difference/linear ratio |
|---|---|---|
| ON | H% ($\Delta y$%) | m dB/n |

Optionally, power back-off is performed based on the second EVM indicator reconfigured by the base station, that is, a second EVM of a signal sent by the terminal is less than the second EVM indicator reconfigured in a corresponding case. In this case, the base station may successfully demodulate the signal.

Optionally, a value of the second EVM indicator may be the same as or different from a value of the first EVM indicator. Optionally, the second EVM indicator and the first EVM indicator may be indicated in same information, or may be indicated in different information. For example, the base station may send one piece of indication information to the terminal, where the indication information may indicate the first EVM indicator and the second EVM indicator. For another example, the base station may send two pieces of indication information to the terminal, where one piece of indication information may indicate the first EVM indicator, and the other piece of indication information may indicate the second EVM indicator.

Optionally, the first EVM indicator and the second EVM indicator may be indicated by using a same EVM indicator. For example, the base station may send an EVM indicator to the terminal, and the EVM indicator may be used as the first EVM indicator and the second EVM indicator.

Based on the foregoing solution, the base station may indicate the information about the power difference to the terminal by using an EVM boosting mode indication. In comparison with that the information about the power difference is indicated by using signaling information such as DCI, RRC, a MAC CE, or a SIB, signaling overheads can be reduced.

The following describes, with reference to the accompanying drawings, a communication apparatus for implementing the foregoing method in embodiments of this application. Therefore, all the foregoing content may be used in the following embodiments. Repeated content is not described again.

FIG. 6 is a block diagram of a communication apparatus 600 according to an embodiment of this application. The communication apparatus 600 may correspondingly implement functions or steps implemented by the terminal device or the network device in the foregoing method embodiments. The communication apparatus may include a processing unit 610 and a transceiver unit 620. Optionally, the communication apparatus may further include a storage unit. The storage unit may be configured to store instructions (code or a program) and/or data. The processing unit 610 and the transceiver unit 620 may be coupled to the storage unit. For example, the processing unit 610 may read the instructions (the code or the program) and/or the data in the storage unit, to implement a corresponding method. The foregoing units may be independently disposed, or may be partially or all integrated.

Optionally, the transceiver unit 620 may include a sending unit and a receiving unit. The sending unit may be configured to perform all sending operations performed by the communication apparatus 600, and the receiving unit may be configured to perform all receiving operations performed by the communication apparatus 600.

In some possible implementations, the communication apparatus 600 can correspondingly implement behavior and functions of the terminal device and the like in the foregoing method embodiments. For example, the communication apparatus 600 may be a terminal device, or may be a component (for example, a chip or a circuit) used in the terminal device. The transceiver unit 620 may be configured to perform all receiving or sending operations performed by the terminal device in the embodiment shown in FIG. 5, for example, S501 and S502 in the embodiment shown in FIG. 5, and/or another process used to support the technology described in this specification. The processing unit 610 is configured to perform all operations other than the receiving and sending operations performed by the terminal device in the embodiment shown in FIG. 5.

For example, the transceiver unit 620 is configured to receive first indication information from the network device, where the first indication information indicates that a DMRS sequence includes a pseudo-random sequence. The processing unit 610 is configured to generate the pseudo-random sequence and data. The transceiver unit 620 is further configured to send the pseudo-random sequence and the data to the network device, where the data is carried on a PUSCH. A nonlinear estimation result of the pseudo-random sequence is used to perform nonlinear compensation on the PUSCH, and a DFT-s-OFDM waveform is used for the pseudo-random sequence and the data.

In some possible implementations, the communication apparatus 600 can correspondingly implement behavior and functions of the network device in the foregoing method embodiments. For example, the communication apparatus 600 may be a network device, or may be a component (for example, a chip or a circuit) used in the network device. The transceiver unit 620 may be configured to perform all receiving or sending operations performed by the network device in the embodiment shown in FIG. 5, for example, S501 and S502 in the embodiment shown in FIG. 5, and/or another process used to support the technology described in this specification. The processing unit 610 is configured to perform all operations other than the receiving and sending operations performed by the network device in the embodiment shown in FIG. 5, for example, S503 in the embodiment shown in FIG. 5, and/or another process used to support the technology described in this specification.

For example, the transceiver unit 620 is configured to send first indication information to the terminal device, where the first indication information indicates that a DMRS sequence includes a pseudo-random sequence. The transceiver unit 620 is further configured to receive the pseudo-random sequence and data from the terminal device, where the data is carried on a PUSCH. A DFT-s-OFDM waveform is used for the pseudo-random sequence and the data. The processing unit 610 is configured to perform nonlinear estimation based on the pseudo-random sequence, and perform nonlinear compensation on the PUSCH based on a nonlinear estimation result.

For operations performed by the processing unit 610 and the transceiver unit 620, refer to the related descriptions in the foregoing method embodiments.

It should be understood that the processing unit 610 in this embodiment of this application may be implemented as a processor or a processor-related circuit component, and the transceiver unit 620 may be implemented as a transceiver, a transceiver-related circuit component, or a communication interface.

Based on a same concept, as shown in FIG. 7, an embodiment of this application provides a communication apparatus 700. The communication apparatus 700 includes a processor 710. Optionally, the communication apparatus 700 may further include a memory 720, configured to store instructions executed by the processor 710, input data needed by the processor 710 to run instructions, or data generated after the processor 710 runs instructions. The processor 710 may implement the methods shown in the foregoing method embodiments by using the instructions stored in the memory 720.

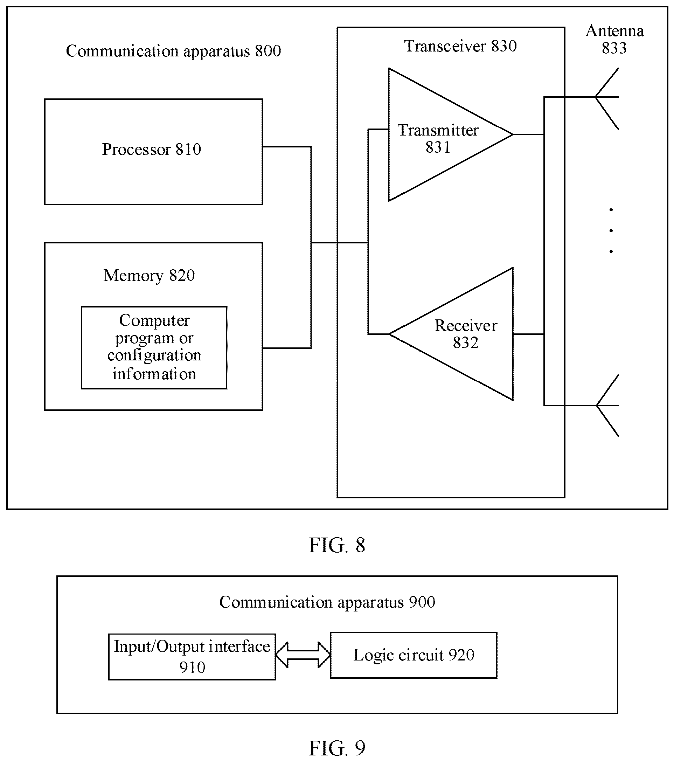

Based on a same concept, as shown in FIG. 8, an embodiment of this application provides a communication apparatus 800. The communication apparatus 800 may be a chip or a chip system. Optionally, in this embodiment of this application, the chip system may include a chip, or may include a chip and another discrete component.

The communication apparatus 800 may include at least one processor 810. The processor 810 is coupled to a memory. Optionally, the memory may be located inside the apparatus, or may be located outside the apparatus. For example, the communication apparatus 800 may further include at least one memory 820. The memory 820 stores a computer program, configuration information, a computer program or instructions, and/or data necessary for implementing any one of the foregoing embodiments. The processor 810 may execute the computer program stored in the memory 820, to implement the method in any one of the foregoing embodiments.

The coupling in this embodiment of this application may be an indirect coupling or a communication connection between apparatuses, units, or modules in an electrical form, a mechanical form, or another form, and is used for information exchange between the apparatuses, the units, or the modules. The processor 810 may cooperate with the memory 820. A specific connection medium between a transceiver 830, the processor 810, and the memory 820 is not limited in this embodiment of this application.

The communication apparatus 800 may further include the transceiver 830, and the communication apparatus 800 may exchange information with another device via the transceiver 830. The transceiver 830 may be a circuit, a bus, a transceiver, or any other apparatus that can be configured to exchange information, and is also referred to as a signal transceiver unit. As shown in FIG. 8, the transceiver 830 includes a transmitter 831, a receiver 832, and an antenna 833. In addition, when the communication apparatus 800 is a chip type apparatus or circuit, the transceiver in the communication apparatus 800 may alternatively be an input/output circuit and/or a communication interface, and may input data (is also referred to as receiving data) and output data (is also referred to as sending data). The processor is an integrated processor, a microprocessor, or an integrated circuit, and the processor may determine output data based on input data.

In a possible implementation, the communication apparatus 800 may be used in a terminal device. Specifically, the communication apparatus 800 may be a terminal device, or may be an apparatus that can support the terminal device in implementing functions of the terminal device in any one of the foregoing embodiments. The memory 820 stores a necessary computer program, a computer program or instructions, and/or data for implementing functions of the management device such as the terminal device in any one of the foregoing embodiments. The processor 810 may execute the computer program stored in the memory 820, to implement the method performed by the terminal device in any one of the foregoing embodiments.

In a possible implementation, the communication apparatus 800 may be used in a network device. Specifically, the communication apparatus 800 may be a network device, or may be an apparatus that can support the network device in implementing functions of the network device in any one of the foregoing embodiments. The memory 820 stores a necessary computer program, a computer program or instructions, and/or data for implementing functions of the network device in any one of the foregoing embodiments. The processor 810 may execute the computer program stored in the memory 820, to implement the method performed by the network device in any one of the foregoing embodiments.

The communication apparatus 800 provided in this embodiment may be used in the terminal device to implement the method performed by the terminal device, or may be used in the network device to implement the method performed by the network device. Therefore, for technical effects that can be achieved by this embodiment, refer to the foregoing method embodiments. Details are not described herein again.

In embodiments of this application, the processor may be a general-purpose processor, a digital signal processor, an application-specific integrated circuit, a field programmable gate array or another programmable logic device, a discrete gate or transistor logic device, or a discrete hardware component, and may implement or execute the methods, steps, and logical block diagrams disclosed in embodiments of this application. The general-purpose processor may be a microprocessor, any conventional processor, or the like. The steps of the method disclosed with reference to embodiments of this application may be directly performed by a hardware processor, or may be performed by using a combination of hardware in the processor and a software module.

In embodiments of this application, the memory may be a non-volatile memory, for example, a hard disk drive (hard disk drive, HDD) or a solid-state drive (solid-state drive, SSD), or may be a volatile memory (volatile memory), for example, a random access memory (random access memory, RAM). Alternatively, the memory may be any other medium that can be configured to carry or store expected program code in a form of an instruction structure or a data structure and that can be accessed by a computer, but is not limited thereto. The memory in embodiments of this application may alternatively be a circuit or any other apparatus that can implement a storage function, and is configured to store a computer program, a computer program or instructions, and/or data.

Based on the foregoing embodiments, refer to FIG. 9. An embodiment of this application further provides another communication apparatus 900, including an input/output interface 910 and a logic circuit 920. The input/output interface 910 is configured to receive code instructions and transmit the code instructions to the logic circuit 920. The logic circuit 920 is configured to run the code instructions to perform the method performed by the terminal device or the network device in any one of the foregoing embodiments.

Optionally, the input/output interface 910 may be an interface on a chip, and the logic circuit 920 may be one or more processors. Optionally, the one or more processors may be located inside the apparatus, or may be located outside the apparatus.

The following describes in detail an operation performed by the communication apparatus used in a terminal device or a network device.

In an optional implementation, the communication apparatus 900 may be used in the terminal device, to perform the method performed by the terminal device, specifically, for example, the method performed by the terminal device in the embodiment shown in FIG. 5.

The input/output interface 910 is configured to input first indication information from a network device, where the first indication information indicates that a DMRS sequence includes a pseudo-random sequence. The logic circuit 920 is configured to generate the pseudo-random sequence and data. The input/output interface 910 is further configured to output the pseudo-random sequence and the data to the network device, where the data is carried on a PUSCH. A DFT-s-OFDM waveform is used for the pseudo-random sequence and the data, and a nonlinear estimation result of the pseudo-random sequence is used to perform nonlinear compensation on the PUSCH.

The communication apparatus 900 provided in this embodiment may be used in the terminal device to implement the method performed by the terminal device. Therefore, for technical effects that can be achieved by this embodiment, refer to the foregoing method embodiments. Details are not described herein again.

In an optional implementation, the communication apparatus 900 may be used in the network device, to perform the method performed by the network device, specifically, for example, the method performed by the network device in the embodiment shown in FIG. 5.

The input/output interface 910 outputs first indication information to a terminal device, where the first indication information indicates that a DMRS sequence includes a pseudo-random sequence. The input/output interface 910 is further configured to input the pseudo-random sequence and data that are from the terminal device, where the data is carried on a PUSCH. A DFT-s-OFDM waveform is used for the pseudo-random sequence and the data. The logic circuit 920 is configured to perform nonlinear estimation based on the pseudo-random sequence, and perform nonlinear compensation on the PUSCH based on a nonlinear estimation result.

The communication apparatus 900 provided in this embodiment may be used in the network device to implement the method performed by the network device. Therefore, for technical effects that can be achieved by this embodiment, refer to the foregoing method embodiments. Details are not described herein again.

Based on the foregoing embodiments, an embodiment of this application further provides a communication system. The communication system includes at least one communication apparatus used in a terminal device and at least one communication apparatus used in a network device. For technical effect that can be achieved, refer to the foregoing method embodiments. Details are not described herein again.

Based on the foregoing embodiments, an embodiment of this application further provides a system. The communication system includes at least one network device and a terminal device.

Based on the foregoing embodiments, an embodiment of this application further provides a computer-readable storage medium. The computer-readable storage medium stores a computer program or instructions. When the instructions are executed, the method performed by the terminal device or the method performed by the network device in any one of the foregoing embodiments is implemented. The computer-readable storage medium may include any medium that can store program code, such as a USB flash drive, a removable hard disk drive, a read-only memory, a random access memory, a magnetic disk, or an optical disc.

To implement the functions of the communication apparatuses in FIG. 6 to FIG. 9, an embodiment of this application further provides a chip, including a processor, configured to support the communication apparatus in implementing the functions of the terminal device or the network device in the foregoing method embodiments. In a possible design, the chip is connected to a memory, or the chip includes a memory. The memory is configured to store a computer program or instructions and data that are necessary for the communication apparatus.

A person skilled in the art should understand that embodiments of this application may be provided as a method, a system, or a computer program product. Therefore, this application may use a form of hardware only embodiments, software only embodiments, or embodiments with a combination of software and hardware. In addition, this application may use a form of a computer program product that is implemented on one or more computer-usable storage media (including but not limited to a disk memory, a CD-ROM, an optical memory, and the like) that include computer-usable program code.

This application is described with reference to the flowcharts and/or block diagrams of the method, the device (system), and the computer program product according to embodiments of this application. It should be understood that a computer program or instructions may be used to implement each procedure and/or each block in the flowcharts and/or the block diagrams and a combination of a procedure and/or a block in the flowcharts and/or the block diagrams. The computer program or instructions may be provided for a general-purpose computer, a dedicated computer, an embedded processor, or a processor of another programmable data processing device to generate a machine, so that the instructions executed by the computer or the processor of another programmable data processing device generate an apparatus for implementing a specified function in one or more procedures in the flowcharts and/or in one or more blocks in the block diagrams.

The computer program or the instructions may alternatively be stored in a computer-readable memory that can indicate the computer or the another programmable data processing device to operate in a specific manner, so that the instructions stored in the computer-readable memory generate an artifact that includes an instruction apparatus. The instruction apparatus implements a specified function in one or more procedures in the flowcharts and/or in one or more blocks in the block diagrams.

The computer program or instructions may alternatively be loaded onto the computer or the another programmable data processing device, so that a series of operation steps are performed on the computer or the another programmable device to generate computer-implemented processing. Therefore, the instructions executed on the computer or the another programmable device provide steps for implementing a specified function in one or more procedures in the flowcharts and/or in one or more blocks in the block diagrams.

It is clear that a person skilled in the art may make various modifications and variations to embodiments of this application without departing from the scope of embodiments of this application. In this case, this application is intended to cover these modifications and variations of embodiments of this application provided that they fall within the scope of protection defined by the following claims and their equivalent technologies.

**Claims**

1. A nonlinear compensation method, comprising:

   receiving first indication information from a network device, wherein the first indication information indicates that a demodulation reference signal DMRS sequence comprises a preset sequence, and a peak to average power ratio PAPR of the preset sequence is higher than a PAPR of a Zadoff-Chu ZC sequence; and
   sending the preset sequence and data to the network device, wherein the data is carried on a physical uplink shared channel PUSCH, and the preset sequence and the data are transmitted by using a discrete Fourier transform spread orthogonal frequency division multiplexing DFT-s-OFDM waveform, wherein
   a nonlinear estimation result of the preset sequence is used by the network device to perform nonlinear compensation on the PUSCH.

2. The method according to claim 1, further comprising:
   receiving first configuration information from the network device, wherein the first configuration information is used to configure one or more of the following:

   a modulation scheme corresponding to the preset sequence;
   a modulation and coding scheme MCS corresponding to the preset sequence; and
   a value of PUSCH power boosting PB corresponding to the preset sequence.

3. The method according to claim 1 or 2, further comprising:

   receiving second indication information from the network device, wherein the second indication information indicates information about a power difference between a power of the preset sequence and a power of the PUSCH; and
   the sending the preset sequence and the data to the network device comprises:
   sending the preset sequence and the data to the network device based on the information about the power difference.

4. The method according to claim 3, further comprising:
   receiving second configuration information from the network device, wherein the second configuration information is used to configure one or more of the following:

   a modulation scheme corresponding to the information about the power difference;
   an MCS corresponding to the information about the power difference; and
   a value of PUSCH PB corresponding to the information about the power difference.

5. A nonlinear compensation method, comprising:

   sending first indication information to a terminal device, wherein the first indication information indicates that a demodulation reference signal DMRS sequence comprises a preset sequence;
   receiving the preset sequence and data from the terminal device, wherein the data is carried on a physical uplink shared channel PUSCH, and the preset sequence and the data are transmitted by using a discrete Fourier transform spread orthogonal frequency division multiplexing DFT-s-OFDM waveform; and
   performing nonlinear compensation on the PUSCH based on a nonlinear estimation result of the preset sequence.

6. The method according to claim 5, further comprising:
sending first configuration information to the terminal device, wherein the first configuration information is used to configure one or more of the following:

    a modulation scheme corresponding to the preset sequence;
    a modulation and coding scheme MCS corresponding to the preset sequence; and
    a value of PUSCH power boosting PB corresponding to the preset sequence.

7. The method according to claim 5 or 6, further comprising:

    sending second indication information to the terminal device, wherein the second indication information indicates information about a power difference between a power of the preset sequence and a power of the PUSCH, and the preset sequence and the data meet the information about the power difference.

8. The method according to claim 7, further comprising:
sending second configuration information to the terminal device, wherein the second configuration information is used to configure one or more of the following:

    a modulation scheme corresponding to the information about the power difference;
    an MCS corresponding to the information about the power difference; and
    a value of PUSCH PB corresponding to the information about the power difference.

9. The method according to any one of claims 1 to 8, wherein the first indication information is carried in downlink control information, radio resource control signaling, a medium access control MAC control element CE, a system message SIB, or a physical downlink shared channel PDSCH.

10. The method according to any one of claims 1 to 9, wherein the first indication information further indicates one or more of the modulation scheme, the MCS, and the value of the PUSCH PB that correspond to the preset sequence.

11. The method according to claim 1 or 5, wherein that the first indication information indicates that the demodulation reference signal DMRS sequence comprises the preset sequence comprises:
the first indication information further indicates a first EVM indicator, and the first EVM indicator indicates that the DMRS sequence comprises the preset sequence.

12. The method according to any one of claims 1 to 11, wherein a time domain resource occupied by the preset sequence does not overlap a time domain resource occupied by the PUSCH.

13. The method according to claim 3, 4, 7, or 8, wherein the second indication information is carried in downlink control information, radio resource control signaling, a medium access control MAC control element CE, a system message SIB, or a physical downlink shared channel PDSCH.

14. The method according to claim 3, 4, 7, 8, or 13, wherein the second indication information further indicates one or more of the modulation scheme, the MCS, and the value of the PUSCH PB that correspond to the information about the power difference.

15. The method according to claim 3 or 7, wherein that the second indication information indicates the information about the power difference between the power of the preset sequence and the power of the PUSCH comprises:
the second indication information further indicates a second EVM indicator, and the second EVM indicator indicates the information about the power difference.

16. A communication apparatus, comprising a unit configured to perform the method according to any one of claims 1 to 4 and 9 to 15, or comprising a unit configured to perform the method according to any one of claims 5 to 15.

17. A computer-readable storage medium, wherein the computer-readable storage medium stores computer-executable instructions, and when the computer-executable instructions are invoked by an electronic apparatus, the electronic apparatus is enabled to perform the method according to any one of claims 1 to 4 and 9 to 15, or the electronic apparatus is enabled to perform the method according to any one of claims 5 to 15.

18. A communication system, comprising an apparatus configured to perform the method according to any one of claims 1 to 4 and 9 to 15 and an apparatus configured to perform the method according to any one of claims 5 to 15.

19. A chip system, wherein the chip system comprises:

a communication interface; and
a processor, configured to: invoke and run the instructions through the communication interface, to enable a device installed with the chip system to perform the method according to any one of claims 1 to 4 and 9 to 15, or to enable a device installed with the chip system to perform the method according to any one of claims 5 to 15.

FIG. 1

FIG. 2

FIG. 3

DMRS

Nonlinear estimation → nonlinear compensation

FIG. 4

| Base station | | Terminal |
|---|---|---|

S501: First indication
information →

← S502: Gold sequence
and data

S503: Perform nonlinear compensation on a
PUSCH based on a nonlinear estimation result
of the Gold sequence

FIG. 5

Communication apparatus 600

Processing unit 610

Transceiver unit 620

FIG. 6

Communication apparatus 700

Processor 710   Memory 720

FIG. 7

Communication apparatus 800

Processor 810

Memory 820

Computer program or configuration information

Transceiver 830

Transmitter 831

Receiver 832

Antenna 833

FIG. 8

Communication apparatus 900

Input/Output interface 910

Logic circuit 920

FIG. 9

## INTERNATIONAL SEARCH REPORT

International application No.

**PCT/CN2024/086431**

### A. CLASSIFICATION OF SUBJECT MATTER

H04B1/12(2006.01)i

According to International Patent Classification (IPC) or to both national classification and IPC

### B. FIELDS SEARCHED

Minimum documentation searched (classification system followed by classification symbols)

IPC:H04B

Documentation searched other than minimum documentation to the extent that such documents are included in the fields searched

Electronic data base consulted during the international search (name of data base and, where practicable, search terms used)

CNTXT; CNKI; ENTXTC; VEN; ENTXT; 3GPP; IEEE: 非线性, 补偿, 估计, 指示, 解调参考信号, 序列, 预设, 随机, 高, 峰均功率比, DMRS, PAPR, PUSCH, non, linear, compensat+, estimat+, indicat+, sequence, preset, random, high

### C. DOCUMENTS CONSIDERED TO BE RELEVANT

| Category* | Citation of document, with indication, where appropriate, of the relevant passages | Relevant to claim No. |
|---|---|---|
| A | CN 115699590 A (QUALCOMM INC.) 03 February 2023 (2023-02-03) description, paragraphs 52 and 65-86, and figure 3 | 1-19 |
| A | CN 115413009 A (HUAWEI TECHNOLOGIES CO., LTD.) 29 November 2022 (2022-11-29) entire document | 1-19 |
| A | CN 113439474 A (ZTE CORP.) 24 September 2021 (2021-09-24) entire document | 1-19 |
| A | US 2023016303 A1 (QUALCOMM INC.) 19 January 2023 (2023-01-19) entire document | 1-19 |

☐ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 May 2024** | **13 June 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/086431**

| Patent document cited in search report | | | Publication date (day/month/year) | Patent family member(s) | | | Publication date (day/month/year) |
|---|---|---|---|---|---|---|---|
| CN | 115699590 | A | 03 February 2023 | WO | 2021237248 | A1 | 25 November 2021 |
| | | | | US | 2021367686 | A1 | 25 November 2021 |
| | | | | EP | 4154410 | A1 | 29 March 2023 |
| | | | | IN | 202227052462 | A | 06 January 2023 |
| CN | 115413009 | A | 29 November 2022 | WO | 2022247655 | A1 | 01 December 2022 |
| CN | 113439474 | A | 24 September 2021 | WO | 2020164099 | A1 | 20 August 2020 |
| US | 2023016303 | A1 | 19 January 2023 | US | 11627018 | B2 | 11 April 2023 |
| | | | | WO | 2023287558 | A2 | 19 January 2023 |

Form PCT/ISA/210 (patent family annex) (July 2022)

**REFERENCES CITED IN THE DESCRIPTION**

**Patent documents cited in the description**

- CN 202310430550